# EUROPÄISCHE PATENTSCHRIFT

(11) **EP 1 024 368 B1**
(45) Veröffentlichungstag und Bekanntmachung des Hinweises auf die Patenterteilung: **02.03.2005**
(21) Anmeldenummer: 00101549.4
(22) Anmeldetag: 27.01.2000
(51) Int. Cl.: G01R 31/00

(54) **Fehlererkennungsschaltung und Fahrzeug bzw. Gerät**
Fault detection device and transport means or device
Appareil de détection de fautes et moyen de transport ou appareil

(30) Priorität: 29.01.1999 US 240115
(43) Veröffentlichungstag der Anmeldung: 02.08.2000
(73) Patentinhaber: DEERE & COMPANY, Moline, Illinois 61265-8098 (US)
(72) Erfinder: Shoemaker, Jim Milton, Horicon, WI 53032 (US)
(74) Vertreter: Magin, Ludwig Bernhard

(56) Entgegenhaltungen:
- US-A- 5 017 910
- US-A- 5 640 093
- PATENT ABSTRACTS OF JAPAN vol. 7, no. 6 (P-167) [1151], 11. Januar 1983 (1983-01-11) & JP 57 163877 A (NIPPON DENSHI)

## Beschreibung

Die Erfindung betrifft eine Fehlererkennungsschaltung, die mit zumindest einer Spannungsquelle und mit wenigstens einem Verbraucher verbindbar ist, mit wenigstens einem Sensor und mit zumindest einem Ausgabetransistor, der zumindest zwei Zustände einnehmen kann, wobei der Sensor den Zustand, in dem sich der Ausgabetransistor befindet, ermitteln kann.

Übliche Fahrzeuge weisen mehrere Magnetventile, Lampen und Relais auf, die über einen Kabelbaum mit einer Fahrzeugsteuerung verbunden sind. Eine falsche Spannung oder eine falsche Last auf einer Leitung kann einen kostenintensiven Schaden an elektrischen oder elektronischen Bauteilen verursachen und kann das Fahrzeug betriebsunfähig machen.

Die US-A-5,017,910 zeigt ein Überwachungssystem mit einer Mehrzahl von Sensoren, welche mit einer zentralen Steuereinheit über getrennte Kabel verbunden sind. Die Steuereinheit weist einen Mikroprozessor auf, welcher einen periodischen Fehlerermittlungsalgorithmus ausführt, während eine Bedienungsperson jedes Kabel im Wechsel manuell biegt. Wenn ein einen Fehler aufweisendes Kabel betätigt wird, reagiert der Algorithmus durch ein Betätigen eines Signalhorns.

Die US-A-5-,640,093 zeigt eine Schaltkreisanalyseeinrichtung, welche eine optische Anzeige liefert, wenn an einen zu prüfenden Schaltkreis ein Verbraucher mit einem zu geringen Widerstand angeschlossen ist.

Die gattungsgemäße JP-A-57163877 offenbart ein Schaltkreisdiagnoseverfahren, welches eine Fehlererkennungsschaltung gemäß dem Oberbegriff des Patentanspruchs 1 verwendet.

Das der Erfindung zugrunde liegende Problem wird darin gesehen, daß zur Ermittlung eines Fehlers die Mitwirkung einer Bedienungsperson notwendig ist.

Dieses Problem wird erfindungsgemäß durch die Lehre der Patentansprüche 1 bzw. 7 gelöst, wobei in den weiteren Patentansprüchen die Lösung in vorteilhafter Weise weiterentwickelnde Merkmale aufgeführt sind.

Auf diese Weise erhält man eine Fehlererkennungsschaltung mit einem verhältnismäßig einfachen Aufbau, die mit einfachen Bauteilen, wie üblichen Transistoren auskommt. Der Ausgabetransistor kann hierbei sowohl als ein NPN- als auch als ein PNP-Transistor ausgeführt sein, wobei die Auswahl beispielsweise in Abhängigkeit von der Spannungsquelle bzw. dem Verbraucher, die/der jeweils mit diesem Transistor in üblicher Weise beispielsweise über Leitungen verbunden ist, erfolgen kann. Einer Spannungsquelle mit höherer Nennspannung kann beispielsweise ein PNP-Transistor zugeordnet werden. Der Transistor kann sich in einem gesättigten oder in einem ungesättigten Zustand befinden. Der Sensor weist einen Fehlererkennungskreis mit einem Sensortransistor auf. Der Sensortransistor steht vorzugsweise über seinen Kollektor und Emitter mit einer Spannungsquelle derart in Verbindung, daß an dem Kollektor eine hohe Spannung anliegt, wenn der Sensortransistor nicht aktiviert ist. In der Schaltung ist ein Selbstdiagnosewiderstand bzw. Haltewiderstand vorgesehen, der dafür sorgt, daß in der Schaltung eine Spannung anliegt, wenn kein Verbraucher angeschlossen ist. Dieser Widerstand ist zwischen die Spannungsquelle und den Transistor geschaltet, so daß der Ausgabetransistor auch ohne angeschlossenen Verbraucher aktiviert werden kann, um beispielsweise zu ermitteln, ob die entsprechende Leitung kurzgeschlossen ist oder der Ausgabetransistor selbst nicht funktionsfähig ist.

In gesättigtem Zustand liegt zwischen seinem Emitter und Kollektor nur eine geringe Spannung an, wenn der Transistor aktiviert ist. Der Transistor ist gesättigt, wenn er durch die an seiner Basis anliegende Spannung aktiviert wurde, und er nicht kurzgeschlossen oder mit einem Verbraucher mit zu hoher Leistungsaufnahme verbunden ist. In diesen Fällen erreicht der Transistor die Sättigung nicht, wodurch zwischen Emitter und Kollektor eine erhöhte Spannung auftritt, die durch den Sensor ermittelt werden kann. Der Transistor wird zur Fehlererkennung über die an seiner Basis anliegende Spannung vorzugsweise nur kurzzeitig aktiviert, so daß eine Sättigung des Transistors eintreten kann, es aber zu keiner Unterbrechung des Betriebs des Verbrauchers bzw. der Last auf der ihm zugeordneten Leitung kommt. Eine solche Schaltung kann beispielsweise an einem Fahrzeug aber auch an einem Arbeitsgerät eingesetzt werden.

Weist die Schaltung einen Mikroprozessor auf, so kann der Sensor an diesen ein Ausgabesignal bzw. einen Ausgabewert liefern, den der Mikroprozessor verarbeiten kann, um beispielsweise ein Warnsignal in Form einer optischen Anzeige oder eines akustischen Signals zu aktivieren. Es kann auch vorgesehen sein, daß der Mikroprozessor den Betrieb des Fahrzeugs oder Arbeitsgeräts teilweise oder vollständig unterbindet, sobald der Sensor eine hohe Spannung an dem Transistor und somit einen Fehler ermittelt.

Über den Mikroprozessor kann auch die an der Basis des Ausgabetransistors anliegende Spannung zur Aktivierung bzw. Deaktivierung des Transistors gesteuert werden.

Wird der Sensortransistor durch den Ausgabetransistor aktiviert, so nimmt die Spannung an dem Kollektor des Sensortransistors einen niedrigeren Wert an, der als Fehlerkennzeichen dienen kann und beispielsweise dem Mikroprozessor zugeleitet bzw. durch diesen aufgenommen und evtl. weiterverarbeitet werden kann.

Der Basis des Ausgabetransistors kann eine vorzugsweise lichtaussendende Diode beispielsweise in Form einer LED-Anzeige vorgeschaltet sein, die anzeigt, ob an der Basis eine Aktivierungsspannung anliegt, so daß eine Bedienungsperson schnell feststellen kann, ob der Transistor oder bei der Verwendung mehrerer Transistoren welcher Transistor aktiviert ist.

Wird ein Fahrzeug oder ein Gerät mit einer solchen Schaltung ausgestattet, so kann eine Fehlerdiagnose während des Betriebs des Fahrzeugs bzw. Geräts durchgeführt werden, ohne daß eine Bedienungsperson hierzu eingreifen muß. Besonders günstig ist eine Verwendung an Fahrzeugen bzw. Geräten zur Rasen-, Gartenund Grundstückspflege, da solche Geräte einfach bzw. robust und kostengünstig sein sollen.

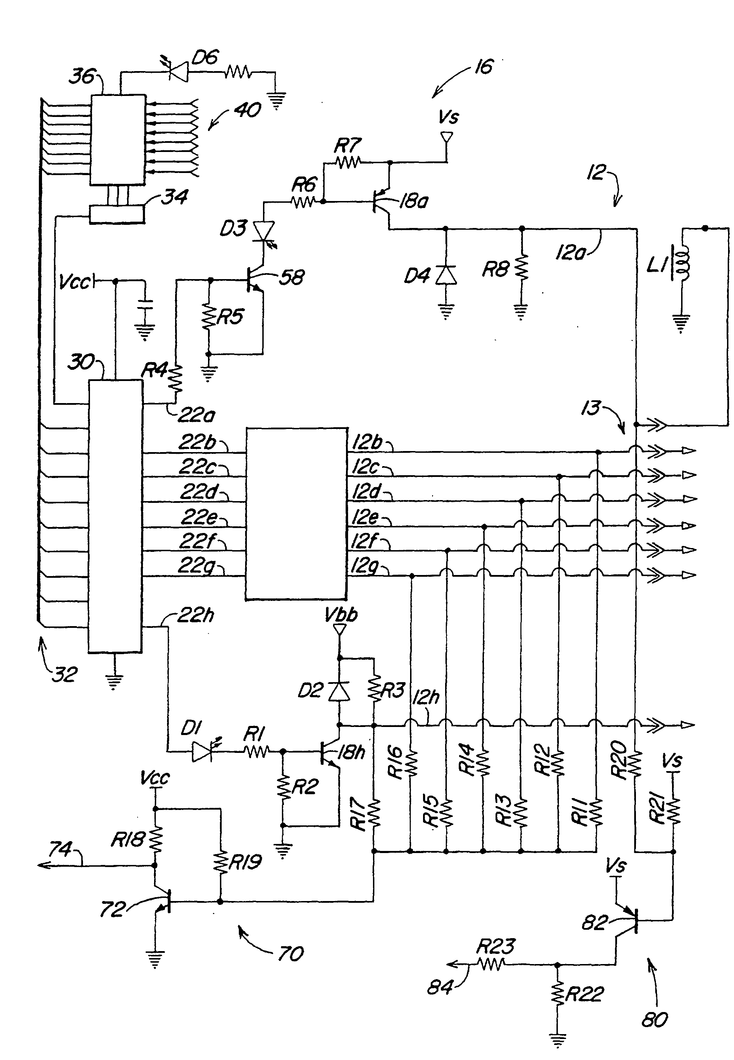

In der Zeichnung ist ein nachfolgend näher beschriebenes Ausführungsbeispiel der Erfindung dargestellt. Es zeigt eine schematische Darstellung eines erfindungsgemäßen Schaltkreises bzw. einer Schaltung.

Es wird nun auf die einzige Figur Bezug genommen, in der eine schematische Darstellung eines Bereichs eines Fahrzeugschaltkreises bzw. Schaltkreises 10 gezeigt wird, der einen Kabelbaum oder ein ähnliches Element mit mehreren Leitungen, das allgemein bei 12 angezeigt wird, und das eine Mehrzahl von Ausgangsleitungen 12a - 12k, die über Anschlüsse 13 mit verschiedenen Belastungen bzw. Verbrauchern wie Solenoiden, Relais und Anzeige Lampen (nicht gezeigt) am Fahrzeug, die solche für den Betrieb der Kraftstoffpumpe und für Verknüpfungsaktionen, wie der Anwesenheit einer Bedienungsperson und des Betriebs der Feststellbremse einschließen, verbunden sind. Die Leitungen 12a - 12k sind mit Ausgabeanschlüssen eines Verstärkerkreises 16 auf einer Hauptsteuertafel verbunden. Wie dargestellt, weist der Verstärkerkreis 16 eine Mehrzahl von Leistungsausgabetransistoren bzw. Ausgabetransistoren 18a - 18k, einen für jede der Ausgabeleitungen 12a - 12k, auf. Detaillierte Ausgabeverstärkerkreise sind nur für den ersten (18a) und letzten (18h) Ausgabetransistor eines Verstärkerkreises 17 gezeigt, wobei der erste Leistungsausgabetransistor 18a ein PNP-Transistor zum Schalten einer Seite hoher Spannung ist, um die Last bzw. den Verbraucher, wie einen Kraftstoffpumpensolenoiden oder andere den Betrieb eines Motors ermöglichende Funktionen auf der Leitung 12a mit einer Spannungsquelle mit einer Nennspannung von 12 V zu verbinden. Die verbleibenden Ausgabetransistoren 18b - 18h (nur der Verstärkerkreis für 18h ist dargestellt, da die Verstärkerkreise für die Transistoren 18b - 18g identisch sind) sind NPN-Transistoren um Solenoide, Relais und Anzeige-Lampen auf den Leitungen 12b - 12h mit Masse zu verbinden. Es soll verstanden werden, daß die Anzahl von Verstärkerkreisen 16 und die Kombination von PNP- und NPN-Ausgabetransistoren 18 variiert werden kann, um an unterschiedliche Anzahlen von Leitungen 12 und an eine wechselnde Polarität angepaßt zu sein, die für die Lasten bzw. Verbraucher notwendig sind, die mit diesen Leitungen verbunden sind.

Die Verstärkerkreise 16 weisen Eingänge 22a - 22h auf, die mit entsprechenden Ausgängen eines parallelen Sperrkreises 30 verbunden sind, welcher wiederum durch einen 8-Bit Ausgabebus 32 mit einem üblichen Chip-Ausgabeverteiler 34 und einem Mikroprozessor 36 verbunden ist. Der Mikroprozessor 36 wählt aufeinanderfolgend verschiedenen Eingaben und Ausgaben, einschließlich Spannungsniveaus, Ausgaben von Fehlererkennungskreisen und Verbindungsschaltern an dem Fahrzeug über ein Terminal 40 aus und liest acht dieser Eingaben und Ausgaben auf einmal ein. Steuersignale werden über den Bus 32 an den Sperrkreis 30 geliefert, welcher vorgewählte Ausgabestellungen in Abhängigkeit von den Signalen, die er von dem Mikroprozessor 36 erhält, aufrechterhält. Jeder der Ausgänge 22a - 22g stellt wahlweise eine Basisfunktionsspannung für die NPN-Ausgabetransistoren 18b - 18h über eine lichtaussendende Diode D1, die mit einem die Basisspannungen begrenzenden Widerstand R1 in Reihe geschaltet ist, zur Verfügung. Ein Widerstand R2 ist zwischen die Basis jedes NPN-Ausgabetransistors und Masse geschaltet. Die Basiswiderstände R1, R2 stellen sicher, daß Streuspannungen den Transistor nicht belasten.

Ein Hochziehwiderstand bzw. ein Widerstand R3 ist zwischen eine gesicherte Spannungsquelle (Vbb) und den Kollektor geschaltet, um die Spannung an den Ausgaben zu Selbstdiagnosezwecke hochzuziehen bzw. zu steigern, wenn keine externen Ausgabeleitungen 12 mit der Hauptsteuertafel verbunden sind. Eine Pufferdiode D2 ist mit dem Kollektor jedes der Ausgabetransistoren 18b - 18h und der Spannungsquelle Vbb zum Schutz verbunden, da viele der Lasten der Leitungen 12, so wie die Solenoide und Relais induktiv sind.

Ein geerdeter Emitterumkehrtransistor 58 weist eine Basis auf, die über einen Spannungsbegrenzungswiderstand R4 mit dem Sperrterminal 22a und mit Masse über den Widerstand R5 verbunden ist. Der Kollektor des Transistors 58 ist über eine lichtaussendende Diode D3 und einen Widerstand R6 mit der Basis des PNP-Ausgabetransistors 18a verbunden, welcher einen Emitter aufweist, der mit der Spannungsquelle Vs verbunden ist. Ein Widerstand R7 ist zwischen die Spannungsquelle Vs und die Basis geschaltet, um sicherzustellen, daß der Transistor nicht durch Streuspannungen belastet wird. Eine Pufferdiode D4 ist mit einem Widerstand R8 parallel zwischen Masse und den Kollektor des PNP-Transistors 18a geschaltet. Der Widerstand R8 hält die Ausgabe in der Leitung 12a niedrig, wenn die Leitung nicht mit ihrer Last verbunden ist, welche wie dargestellt, ein Haltesolenoid L1 einer Kraftstoffpumpensteuerung (oder einer anderen die Funktion eines Antriebs ermöglichende Einrichtung) ist.

Wenn das Sperrterminal 22a eine hohe Spannung erhält, werden die Transistoren 58 und 18a aktiviert und die Diode D3 liefert eine sichtbare Anzeige, daß ein Kraftstoffsolenoidsignal vorhanden und die Leitung 12a angeschaltet ist (in der Nähe des Spannungsniveaus der Spannungsquelle Vs). Wenn irgendeines der Terminals 22b - 22h eine hohe Spannung aufweist, wird der entsprechende der Ausgabetransistoren 18b - 18h aktiviert, um die entsprechende der Ausgabeleitungen 12b - 12h zu erden. Ein visuelles Aktivierungssignal wird durch die Diode D1 für diesen Ausgabetransistor geliefert. Es kann auch eine LED Anzeige in dem Schaltkreis vorgesehen sein, die mit den Terminals 40 des Mikroprozessors 36 verbunden ist, so daß ein Techniker mit einem Blick erkennen kann, welche Eingaben aktiviert sind, wie auch welche der Ausgabeleitungen 12a - 12h in angeschaltetem Zustand sind.

Ein Fehlererkennungskreis, der allgemein bei 70 gezeigt wird, ist mit den Ausgängen 12b - 12g der NPN-Ausgabetransistoren 18b - 18h jeweils über Spannungsreduzierungswiderstande R11 - R17 verbunden. Der Schaltkreis 70 weist einen NPN-Sensortransistor 72 mit einem geerdeten Emitter und einem Kollektorausgang 74 auf. Der Kollektor ist über einen Widerstand R18 mit einer Spannungsquelle Vcc mit einer Nennspannung von ungefähr 5 V verbunden, so daß, wenn der Sensortransistor 72 nicht aktiviert ist, der Ausgang 74 eine hohe Spannung (ungefähr +5 V) aufweisen wird. Die Basis des Sensortransistors 72 ist über die Widerstände R11 - R17 mit den Ausgangsleitungen 12b - 12h verbunden. Wenn alle NPN-Ausgabetransistoren 18b - 18h aktiviert und gesättigt sind, wird die Spannung Vce(sat) des Transistors sehr niedrig und im Bereich von 0,1 bis 0,2 Volts sein, so daß die Spannung an der Basis des Sensortransistors 72 geringer als 0,5 V und unter der Basis-Emitter Aktivierungsspannung des Sensortransistors 72 liegen wird. Wenn manche der Ausgabetransistoren 18b - 18h nicht aktiviert und manche aktiviert sind (wie es der Fall ist, wenn das Fahrzeug in Betrieb ist) oder wenn einer oder mehrere der Ausgabetransistoren nicht gesättigt ist, wird die Spannung an der Basis des Sensortransistors 72 über die Aktivierungsspannung steigen, wodurch verursacht wird, daß der Ausgang 74 eine niedrige Spannung (ungefähr 0,1 V) aufweist. Ein Hochziehwiderstand bzw. Haltewiderstand R19 ist zwischen die Spannungsquelle Vcc und die Basis des Transistors 72 geschaltet, um den Schaltkreis 70 empfindlicher gegenüber dem Zustand, in dem ein NPN-Ausgangstransistor nicht gesättigt ist, zu machen. Da die Ausgabetransistoren 18b - 18h normalerweise gesättigt sind, wenn sie aktiviert und ordentlich mit der Last der Leitungen 12b - 12g verbunden sind, sollte ein kurzfristiges Schalten aller NPN-Transistoren in dem Ausgabekreis 16 in den eingeschalteten Zustand bewirken, daß der Ausgang 74 eine hohe Spannung aufweist (die Spannung an der Basis des Sensortransistors 72 wird unter die Anschaltspannung fallen, wenn alle NPN Transistoren Sättigung erreichen), außer es liegt ein Fehler, wie eine unpassende Last, ein durchgebrannter NPN-Transistor in dem Kreis 16, ein Kurzschluß mit der Spannungsquelle in einer der Leitungen 12 vor.

Der Ausgang 74 des Sensortransistors 72 ist mit dem Eingangskreis 40 des Mikroprozessors 36 verbunden, welcher feststellt, ob die hohe oder die niedrige Bedingung an dem Ausgang 74 existiert. Wenn die Bedingung an dem Ausgang 74 für den gegebenen Eingang zu dem Kreis 16 falsch ist, kann der Mikroprozessor 36 alle Ausgänge schließen und eine Warnung liefern, bis der Fehler korrigiert ist. Durch ein Aktivieren aller NPN Ausgänge 12b - 12h außer einem für eine kurze Zeitdauer, vorzugsweise weniger als 50 ms für eine Widerstandsbelastung und mehrere hundert Millisekunden für eine induktive Last, kann diese einzelne Ausgangsleitung geprüft werden. Die Spannung in der einzelnen deaktivierten Leitung sollte in Richtung der Versorgungsspannung ansteigen und verursachen, daß die Spannung an der Basis des Sensortransistors 72 über die Aktivierungsspannung des Sensortransistors ansteigt, was zu einem niedrigen Spannungsniveau an dem Ausgang 74 führt. Wenn das niedrige Niveau für die spezielle Leitung, die geprüft wird, festgestellt wird, schreitet der Mikroprozessor 36 in dem Ablauf voran, um die nächste der Leitungen 12 zu prüfen. Wie auch immer, wenn zu irgendeiner Zeit eine Nichtübereinstimmung zwischen der Last und der Leitung, die geprüft wird, vorliegt oder wenn die Leitung mit Masse kurzgeschlossen ist, wird die Spannung in dieser Leitung nicht ausreichend ansteigen, um den Sensortransistor 72 zu aktivieren und der Mikroprozessor 36 wird eine Fehleranzeige liefern und den Ausgang schließen. Die Testzeitdauer ist für jede Leitung so kurz, daß ein normaler Betrieb des Fahrzeugs während des Ablaufs nicht behindert wird, wenn keine Fehler gefunden werden. Daher können Kurzschlußfehlertests der Ausgänge in regelmäßigen Intervallen während des Fahrzeugbetriebs durchgeführt werden. Beispielsweise können durch ein Testen eines Ausgangs alle 50 ms alle Ausgänge nach Kurzschlüssen in weniger als einer Sekunde geprüft werden. Der Mikroprozessor 36 kann den Betrieb sofort beenden, um teueren und zeitaufwendigen Bauteilbeschädigungen vorzubeugen.

Ein Schaltkreis 80 ähnlich dem Schaltkreis 70 ist mit der PNP-Ausgangstransistorleitung 12a verbunden. Ein PNP-Sensortransistor 82 weist einen Emitter, der mit der Spannungsquelle Vs verbunden ist, und eine Basis auf, die mit der Leitung 12a über einen Widerstand R20 verbunden ist. Die Basis ist ebenso über einen Hochzieh-Widerstand bzw. Haltewiderstand R21 verbunden. Wenn der PNP-Ausgangstransistor 18a nicht aktiviert ist, fällt die Spannung an der Basis des PNP Sensortransistors 82, wodurch der Transistor 82 aktiviert wird und das Niveau an dem Ausgang 84 in den hohen Zustand gelangt. Wenn der Transistor 18a aktiviert und gesättigt ist, was bei normaler Last der Fall sein sollte, wird die Spannung in der Leitung 12a in Richtung der Spannung der Spannungsquelle Vs ansteigen und verursachen, daß der Sensortransistor 82 sich deaktiviert, was wiederum bewirkt, daß der Ausgang 84 auf ein niederes Niveau gelangt. Wie auch immer, wenn die Leitung 12a unrichtig mit Masse oder unrichtig mit einem Hochstrombauteil verbunden ist (wie der Anzugsspule des Kraftstoffmagnetventils, anstelle der einen geringeren Strom benötigenden Haltespule), wird der Transistor 18 nicht die Sättigung erreichen und die Spannung der Leitung wird nicht ausreichen, um den Transistor 82 zu deaktivieren. Der Ausgang 84 wird in dem Zustand hoher Spannung verbleiben. Ein Reduzierungswiderstand 22 ist mit dem Kollektor des Transistors 82 verbunden, um sicherzustellen, daß der Ausgang 84 eine geringe Spannung aufweist, wenn der Transistor 82 nicht aktiviert ist. Ein Widerstand R23 ist zwischen den Kollektor und den Ausgang 84 geschaltet, um die Ausgangsspannung zu begrenzen und das Spannungsniveau im Zustand hoher Spannung zu reduzieren, um mit dem Eingangswahlkreis des Mikroprozessors 36 kompatibel zu sein, der vorzugsweise mit einer Spannung arbeitet, die viel niedriger ist als die Spannung der Spannungsquelle Vs, um die Hauptsteuertafel selbst bei extrem niedrigen Spannungen wie bei einem Kaltstart des Fahrzeugs von einem Zurücksetzen abzuhalten. Der Mikroprozessor 36 prüft die Bedingung an dem Ausgang 84 und wird, wenn der Zustand hoher Spannung bemerkt wird, wenn der Ausgabetransistor 18a aktiviert ist, einen Fehler anzeigen und die Ausgänge schließen. Durch die Verwendung eines getrennten Schaltkreises 80 für den PNP Ausgangstransistor 18a, kann die Empfindlichkeit gegenüber Fehlern gesteigert werden und das Kraftstoffpumpenventil L1 oder andere positiv schaltende, den Antrieb eine Funktion ermöglichende Verbraucher können häufiger getestet werden als die Verbraucher auf den verbleibenden Leitungen 12b - 12h. Eine Anzeigediode D6 ist mit dem Mikroprozessor 36 verbunden und liefert ein herzschlagähnliches Signal während des Betriebs wie auch ein kodiertes Signal, um eine visuelle Indentifikation zu liefern, wenn ein Fehler festgestellt wird.

Bei einem Starten des Fahrzeugs, wird der Fahrzeugschaltkreis 10 zuerst auf größere Verkabelungsfehler geprüft, so ob die Spannungsquelle Vs mit einer der Leitungen 12b - 12h verbunden oder die Leitung 12 geerdet oder mit einer Hochstromspule anstatt mit einer Niedrigstromspule L1 verbunden ist. Alle Ausgaben des Verstärkerkreises 16 sind deaktiviert und der Mikroprozesser 36 prüft, ob an dem Ausgang 74 ein niedriger Wert oder an dem Ausgang 84 ein hoher Wert vorliegt (die Solenoidspulen oder eine andere Verkabelung auf an den Leitungen 12 nach außen oder die Widerstände R3 und R8 belasten die Transistoren 72 und 82 in diese Stellung). Wenn diese Bedingungen einen Fehler anzeigend nicht erreicht werden, wird das Fehlerkennzeichen gesetzt und der Start wird abgebrochen. Wenn die ersten Tests erfolgreich sind, werden die NPN Ausgänge 12b - 12h alle aktiviert und die Ausgabetransistoren 18 sollten alle gesättigt werden, um den Sensortransistor 72 zu deaktivieren und um einen hohen Spannungszustand an dem Ausgang 74 zu liefern, außer wenn ein NPN-Transistor durchgebrannt ist oder die Spannungsquelle Vs unpassend verbunden oder mit einem der Ausgänge 12b - 12h kurzgeschlossen ist. Der PNP-Ausgabetransistor ist ebenfalls aktiviert, was dazu führen sollte, daß der Sensortransistor 82 deaktiviert ist und an dem Ausgang 84 ein niedriger Wert anliegt, außer wenn die Leitung 12a unpassend mit einer hohen Stromlast wie einer Anzugspule oder Masse verbunden ist. Wenn die vorangegangenen Test keine Fehler anzeigen, initiiert der Mikroprozessor 36 das normale Startprogramm des Fahrzeugs. Wenn nicht, wird das Fehlerkennzeichen gesetzt, der Vorgang wird abgebrochen, und ein Fahrzeugbetrieb wird gesperrt. Der Mikroprozessor 36 zündet die bestimmte Kodierung oder Kodierungen, die bestimmten, ermittelten Fehlern zugeordnet sind, an der lichtaussendenden Diode D6.

Wahrend eines Betriebs der Maschine, werden die Ausgänge 12b - 12h all 50 ms auf eine Verbindung mit Masse geprüft, indem nur eine Ausgabeleitung auf einmal kurz aktiviert wird und der niedrige Zustand an dem Ausgang 74, wie zuvor beschrieben, geprüft wird. Ebenso werden die Ausgänge 12b - 12h regelmäßig geprüft, in dem alle NPN-Ausgabetransistoren 18b - 18h bis auf einen kurz aktiviert und geprüft werden, um festzustellen, ob der Ausgang 74 einen niedrigen Wert aufweist. Wenn der Wert an dem Ausgang 74 nicht niedrig ist, ist die bestimmte Ausgabeleitung für den Transistor der gerade deaktiviert ist, möglicherweise mit Masse kurzgeschlossen. Der PNP-Transistorausgang 12a wird ebenfalls, wie oben dargelegt, geprüft, vorzugsweise häufiger als die NPN Ausgänge. Wenn ein bestimmter Test nicht erfolgreich ist, wird das Fehlerkennzeichen gesetzt und ein Fehlercode leuchtet an der Diode D6 auf.

Nur beispielhaft werden die folgenden Bauteilkennwerte vorgeschlagen:

| | |
|---|---|
| R1, R6 | 220 Ω |
| R2 - R5, R7, R8 | 10 kΩ |
| R11 - R20 | 10 kΩ |
| R21 | 1,2 kΩ |
| R22, R23 | 10 kΩ |

Aufgrund der Beschreibung des bevorzugten Ausführungsbeispiels, wird es deutlich werden, daß verschiedenen Modifikationen gemacht werden können, ohne von dem Bereich Erfindung, wie er durch die folgenden Ansprüche bestimmt wird, abzuweichen.

## Patentansprüche

1. Fehlererkennungsschaltung, die mit zumindest einer Spannungsquelle (Vs, Vbb, Vcc) und mit wenigstens einem Verbraucher (L1) verbindbar ist, mit wenigstens einem Sensor und mit zumindest einem Ausgabetransistor (18a - 18k), der zumindest zwei Zustände einnehmen kann, wobei der Sensor den Zustand, in dem sich der Ausgabetransistor (18a - 18k) befindet, ermitteln kann, **dadurch gekennzeichnet, daß** der Sensor einen Fehlererkennungskreis (70, 80) mit einem Sensortransistor (72, 82) aufweist, der vorzugsweise durch die an dem Kollektor des Ausgabetransistors (18a - 18k) anliegende Spannung aktivierbar ist und dass die Fehlererkennungsschaltung einen Haltewiderstand (R3, R19, R21) aufweist, der in der Schaltung eine Spannung aufrechterhält, wenn kein weiterer Verbraucher (L1) angeschlossen ist.

2. Schaltung nach Anspruch 1, **dadurch gekennzeichnet, daß** der Sensor ermittelt, ob sich der Ausgabetransistor (18a - 18k) in einem gesättigten Zustand befindet.

3. Schaltung nach einem oder mehreren der vorherigen Ansprüche, **dadurch gekennzeichnet, daß** der Sensor zumindest einen Ausgabewert an einen Mikroprozessor (36) liefern kann.

4. Schaltung nach einem oder mehreren der vorherigen Ansprüche, **dadurch gekennzeichnet, daß** die Steuerspannung des Ausgabetransistors (18a - 18k) vorzugsweise durch den Mikroprozessor (36) bestimmbar ist.

5. Schaltung nach Anspruch 5, **dadurch gekennzeichnet, daß** die am Kollektor des Sensortransistors (72, 82) vorliegende Spannung zumindest ein Ausgabesignal des Sensors ist bzw. bestimmt.

6. Schaltung nach einem oder mehreren der vorherigen Ansprüche, **gekennzeichnet durch** ein Anzeigemittel, vorzugsweise in Form einer lichtaussendenden Diode (D1, D3), die vorzugsweise anzeigt, ob an der Basis des Ausgabetransistors (18a - 18k) eine Aktivierungsspannung anliegt.

7. Fahrzeug bzw. Gerät vorzugsweise zur Rasen-, Garten- und Grundstückspflege mit einer Schaltung nach einem oder mehreren der vorherigen Ansprüche.

## Claims

1. An error detection circuit which can be connected to at least one voltage source (Vs, Vbb, Vcc) and at least one load (L1), with at least one sensor and with at least one output transistor (18a - 18k) which can assume at least two states, wherein the sensor can detect the state in which the output transistor (18a - 18k) is present, **characterized in that** the sensor comprises an error detection circuit (70, 80) with a sensor transistor (72, 82) which can preferably be activated by the voltage present on the collector of the output transistor (18a - 18k), and **in that** the error detection circuit comprises a pull-up transistor (R3, R19, R21) which maintains a voltage in the circuit when no further load (L1) is connected.

2. A circuit according to claim 1, **characterized in that** the sensor determines whether the output transistor (18a - 18k) is present in a saturated state.

3. A circuit according to one or more of the preceding claims, **characterized in that** the sensor can supply at least one output value to a microprocessor (36).

4. A circuit according to one or more of the preceding claims, **characterized in that** the control voltage of the output transistor (18a - 18k) can preferably be determined by the microprocessor (36).

5. A circuit according to claim 5, **characterized in that** the voltage present on the collector of the sensor transistor (72, 82) is or determines at least one output signal of the sensor.

6. A circuit according to one or more of the preceding claims, **characterized by** an indicator means, preferably in the form of a light emitting diode (D1, D3), which preferably indicates whether an activating voltage is present on the base of the output transistor (18a - 18k).

7. A vehicle or implement, preferably for lawn, garden and plot care, with a circuit according to one or more of the preceding claims.

## Revendications

1. Dispositif détecteur d'erreurs, qui peut être raccordé à au moins une source de tension (Vs, Vbb, Vcc) et à au moins une charge (L1), comprenant au moins un capteur et au moins un transistor de sortie (18a-18k), qui peut accepter au moins deux états, le capteur pouvant déterminer l'état dans lequel se trouve le transistor de sortie (18a-18k), **caractérisé en ce que** le capteur comporte un circuit de détection d'erreurs (70, 80) avec un transistor de détection (72, 82), qui peut être activé de préférence par la tension délivrée au collecteur du transistor de sortie (18a-18k), et **en ce que** le circuit de détection d'erreurs comporte une résistance de maintien (R3, R19, R21), qui maintient une tension dans le dispositif lorsque aucune charge supplémentaire (L1) n'est raccordée.

2. Dispositif selon la revendication 1, **caractérisé en ce que** le capteur détermine si le transistor de sortie (18a-18k) est à l'état saturé.

3. Dispositif selon une ou plusieurs des revendications précédentes, **caractérisé en ce que** le capteur peut transmettre vers un microprocesseur (36) au moins une valeur de sortie.

4. Dispositif selon une ou plusieurs des revendications précédentes, **caractérisé en ce que** la tension de commande du transistor de sortie (18a-18k) peut être déterminée de préférence par le microprocesseur (36).

5. Dispositif selon la revendication 5, **caractérisé en ce que** la tension délivrée au niveau du collecteur du transistor de détection (72, 82) est ou détermine au moins un signal de sortie du capteur.

6. Dispositif selon une ou plusieurs des revendications précédentes, **caractérisé par** un moyen d'affichage, de préférence sous la forme d'une diode électroluminescente (D1, D3), qui signale de préférence si une tension d'activation est appliquée à la base du transistor de sortie (18a-18k).

7. Véhicule ou appareil, de préférence pour l'entretien des pelouses, jardins et terrains, comportant un dispositif selon une ou plusieurs des revendications précédentes.
